# EUROPEAN PATENT APPLICATION

(11) **EP 2 216 837 A1**
(43) Date of publication of application: **11.08.2010**
(21) Application number: 09001729.4
(22) Date of filing: 07.02.2009
(51) Int. Cl.: H01L 41/09

(54) **Piezoelectric motor**

(71) Applicant: Physik Instrumente (PI) GmbH & Co. KG, 76228 Karlsruhe (DE)
(72) Inventor: Koc, Burhanettin, 76139 Karlsruhe (DE); Delibas, Bülent, 76646 Bruchsal (DE); Rothardt, Oliver, 76137 Karlsruhe (DE)

(57) **Abstract**

The invention relates to a piezoelectric motor (1), comprising: a stator (2), a piezoelectric actuator (3) and a movable unit (4), wherein said movable unit (4) is coupled with said actuator (3) so as to move relative to said stator due to frictional coupling when said actuator is excited by an electric driving power. The object of the invention is to provide a piezoelectric motor that can be realized at low cost and can be miniaturized easily. In order to solve the above defined object, the invention provides a piezoelectric motor, wherein said actuator is fixed to said stator at fixing portions (32,33), which are located on opposite ends of said actuator (3).

## Description

The invention relates to a piezoelectric motor, comprising: a stator, a piezoelectric actuator and a movable unit, whereby said movable unit is coupled with said actuator so as to move relative to said stator due to frictional coupling when said actuator is excited by an electric driving power.

The piezoelectric motor according to the invention preferably operates at a mechanical resonance frequency of its vibrating element. The piezoelectric vibrating element is often the major component of the actuator. Therefore, the terms "actuator" and "piezoelectric vibrating element" are often used synonymously in this specification.

Performance such as speed, generated force and efficiency of a piezoelectric motor highly depends on boundary conditions of piezoelectric actuators and vibrating element(s) in particular. In order not to unduly suppress useful vibration generated by the actuator, it is preferred to support the piezoelectric element at its nodal position. According to the prior art, vibrating piezoelectric elements in piezoelectric ultrasonic motors as, for example, disclosed in the document US20080073999A1 can hardly be supported at a nodal position. Furthermore, it is also hardly possible to support a vibrating element at a nodal position in case the vibrating element is miniaturized as, for example, disclosed in the document US20080297923. In summary, holding the vibrating element at its nodal position is difficult. In addition, there are cases that vibrating elements in a piezoelectric motor may have at least two orthogonal vibration modes such as longitudinal and flexural resonance modes to be excited at the same time. In this case, certain dimension ratios such as length to thickness or length to width have to be maintained in a close tolerance. This tight tolerance of dimension ratio matching could increase the vibrating element cost.

The object of the invention is to provide a piezoelectric motor that can be realized at low cost and can be miniaturized easily.

In order to solve the above defined object, the invention provides a piezoelectric motor, comprising: a stator, a piezoelectric actuator and a movable unit, whereby said movable unit is coupled with said actuator so as to move relative to said stator due to frictional coupling when said actuator is excited by an electric driving power, wherein said actuator is fixed to said stator at fixing portions, which are located on opposite ends of said actuator. In this context, the term 'fixed' means a boundary condition where the actuator at least in the region of the fixing portions has no degree of freedom, and said term 'fixed' stands in contrast to the term 'supporting', describing a state where at least one degree of freedom is existing.

The piezoelectric motor according to the invention preferably operates at a mechanical resonance frequency of its vibrating element, which is, most preferably, in an ultrasonic range. In order not to suppress the useful vibration, the piezoelectric vibrating element is held fixed from its nodal position at fixing portions, which are located on opposite ends thereof. Fixing the actuator to the stator at fixing portions, which are located on opposite ends of the actuator, makes the piezoelectric motor mechanically more stable. It is to be understood that in case the actuator having more than two fixing portions, two fixing portions are arranged at opposite ends in each case. In addition, realization of a small actuator is possible due to fact that the actuator is held from its end positions. The vibrating piezoelectric element is preferably a piezoelectric ceramic plate in bulk or multilayered form, and may have rectangular, square or other shapes. Conductive electrodes divide the ceramic into two equal symmetric segments/sections. Preferably, a spherical ball made of hard ceramic such as aluminum oxide (Al2O3) or Silicon Nitride (Si3N4) or hard metal alloy (or carbides) such as Tungsten Carbide is attached at the center of the vibrating piezoelectric element as a friction portion in order to provide a high friction low wear contact with the movable unit. In a preferred embodiment, a friction plate attached to a sliding element of the movable unit touches a friction tip at the center of the spherical ball, and two spherical balls together with the friction tip on the actuator guide the movable unit, wherein a preload is maintained by magnetic force obtained by two magnets attached to the sliding element and attracted by the stator, which is preferably a ferrous base plate made from steel. The piezoelectric motor according to the invention can be realized at low cost and can be miniaturized easily. In particular, a piezoelectric actuator/vibrating element of the motor according to invention can be manufactured easily without considering any tight dimension tolerances. Furthermore, holding the piezoelectric actuator/vibrating element from two end positions does not degrade a vibration performance.

Preferred embodiments are claimed in the subclaims.

The piezoelectric motor according to the invention is preferably a piezoelectric ultrasonic motor, which operates in an ultrasonic range at the second longitudinal resonance frequency of its vibrating element. While exciting the motor at its second longitudinal resonance frequency, it is not needed to adhere to narrow dimension tolerances of the piezoelectric element. It is also possible to operate the piezoelectric ultrasonic motor in an ultrasonic range at any higher even multiple of the longitudinal resonance frequency. This requires small structures, so that the present invention is particularly applicable to miniaturization applications.

It may prove useful if said actuator is fixed to the stator at said fixing portions by fixing means. A preferred fixing means is an adhesive so that the fixing is realized by adhesive bonding or glueing, respectively. This fixing means allows a very practicable, easy and cheap fixation of the actuator to the stator. However, it is also possible to use other fixing means according to which the actuator is soldered or welded to the stator. Furthermore, it is possible to use screws or a screwing structure, respectively, as for the fixing means.

It may prove useful if said actuator is shaped as a bar or plate, wherein said fixing portions are located on opposite edges of said bar or plate. The vibrating element of the actuator can be easily provided in such shape and can be easily fixed on opposite edges, which simplifies the handling during an assembly work.

It may prove advantageous if said actuator is shaped as a polygonal plate, preferably a square plate, wherein said fixing portions are located on the corners of said plate. If the actuator/vibrating element is embodied as a rectangular bar or square plate, the vibrating piezoelectric element may be operated at its second longitudinal mode mechanical resonance frequency, so that a useful displacement is at the center of the actuator/vibrating element. In such case, it is particularly useful that two end positions of the actuator/vibrating element are fixed so as not to disturb the useful vibration at the center.

It may prove helpful if said movable unit is frictionally coupled with a friction portion of said actuator, wherein said friction portion is located between said fixing portions, preferably in a centered position between said fixing portions. The center of the actuator shows the largest vibration, whereby the vibration is used to move the movable unit due to frictional coupling with the actuator.

It may prove useful if said friction portion projects from one of the side surfaces of said plate. In such case, it is easy to bring the friction portion in contact with the movable unit, which is preferably arranged in parallel with the surface, from which the friction portion projects. According to this embodiment, a very compact motor can be provided.

It may prove advantageous if said piezoelectric actuator is provided with an arrangement of conductive electrodes, such that, upon application said of said electric driving power to said arrangement, said friction portion is displaced along an axis. More particularly, the piezoelectric actuator/vibrating element is deformed under the impact of the electric driving power, so that the friction portion is displaced with regard to the fixing portions. In such case, the motor can be operated with high efficiency and high accuracy, as the displacement of the friction portion can be controlled by the amount of electric driving power applied to the arrangement of conductive electrodes.

It may prove beneficial if said piezoelectric actuator is provided with first and second arrangements of conductive electrodes, such that, upon application said electric driving power to said first and second arrangements, said friction portion is displaced along first and second axes, respectively, wherein said first axis is substantially perpendicular to said second axis. Again, the piezoelectric actuator/vibrating element is deformed under the impact of the electric driving power, so that the friction portion is displaced with regard to the fixing portions. Here, the fixing portions are preferably arranged in line with the first and second axes, where in each case two fixing portions are arranged in line with one axis at opposite ends of the piezoelectric actuator. The motor according to this embodiment allows the friction portion being displaced and the movable unit being moved in a plane. The displacement of the friction portion in the plane can be controlled by the amounts of electric driving power applied to the respective arrangements of conductive electrodes.

It may prove profitable if said first and/or said second axis substantially extends in parallel with the largest diameter of said actuator. In a square-plate shaped actuator, the largest diameters are the diagonals connecting opposite corners. As will be understood, the maximum vibration occurs in the center of the vibrating element, so that the maximum of vibration of the vibrating element can be used to impart motion to the movable unit.

It may prove useful if said piezoelectric actuator is of a multilayer type, wherein conductive electrodes are embedded in said piezoelectric actuator in several layers, preferably in parallel fashion. The motor according to this embodiment can be configured even more compact, as the piezoelectric actuator of a multilayer type can be made smaller and requires less electric driving power or less electric driving voltage, respectively. The embedded conductive electrodes are preferably electrically connected to outer conductive electrodes being arranged on a surface or on surfaces of the piezoelectric element.

It may prove advantageous if said movable unit is rotatable about an rotation axis with regard to said stator, wherein said actuator is frictionally coupled with said movable unit in an eccentric position with regard to said rotation axis. In such arrangement, a complex rotary motor may be operated by means of a simple linear piezoelectric actuator. The larger the eccentricity, the larger is the torque applied by the actuator.

It may prove helpful if said axis is tangentially to a circle around said rotation axis. In such arrangement, a rotary motor can be operated with high efficiency by the linear actuator.

It may prove advantageous if said actuator is preloaded in the direction of said movable unit by means of a spring, so as to enhance the frictional coupling between said actuator and said movable unit. In such arrangement, the actuator can impart large frictional forces to the movable unit.

It may prove useful if said stator comprises a hole, from which the spring projects in order to preload said actuator. The elements of the motor according to this embodiment can be compactly arranged in miniaturized applications, such as cameras, mobile phones and the like. The spring is preferably a leaf spring.

A preferred aspect of the invention relates to an autofocus module for a camera, comprising a piezoelectric motor according to any one of the preceding claims. In case of a camera application for lens positioning such as auto focus or zoom, a small sized camera module that is critical for mobile phone application or the like can be realized. A preferred actuator structure is one that can move the movable unit along two substantially orthogonal axes. Usage of such an actuator for optical image stabilization (OIS) applications could simplify the mechanical system.

Another preferred and independent aspect of the invention relates to piezoelectric actuator, capable of moving a movable unit relative to a stator due to frictional coupling when said actuator is excited by a electric driving power, said actuator comprising a piezoelectric vibrating portion, a friction portion and fixing portions, at which the actuator is to be fixed to a stator, wherein said fixing portions are located on opposite sides of said actuator. Such actuator can be configured in a very compact fashion and enables various configurations of miniaturized piezoelectric motors of linear or rotary type.

### The invention will now be described with reference to the appended drawings:

### Brief description of drawings

- Fig. 1: is an exploded perspective view of the piezoelectric motor according to a first embodiment of the invention, wherein the motor is embodied as linear motor.
- Fig. 2: is a perspective view of a piezoelectric actuator comprising a piezoelectric vibrating element on which conductive electrodes are seen on the front surface.
- Fig. 3: is a sectional view on line III-III of the piezoelectric actuator according to Fig. 2.
- Fig. 4: is a schematic view of a piezoelectric actuator as seen from the side, wherein the piezoelectric vibrating element has the same polarization directions in two different sections.
- Fig. 5: is a schematic view of a piezoelectric actuator as seen from the side, wherein the piezoelectric vibrating element has opposite polarization directions in two different sections.
- Fig. 6: shows perspective views of a computer model of the piezoelectric actuator under different load conditions, wherein Fig. 6a shows a rest condition of the actuator, Fig. 6b shows a condition of a deformation of the actuator upon excitation by an electric driving power in the second longitudinal mode of the piezoelectric vibrating element at the end of a first cycle, and Fig. 6c shows a condition of a deformation of the actuator upon excitation by the electric driving power in the second longitudinal mode of the piezoelectric vibrating element at the end of a second cycle.
- Fig. 7: is a front view of the piezoelectric motor according to the first embodiment of the invention in an assembled condition.

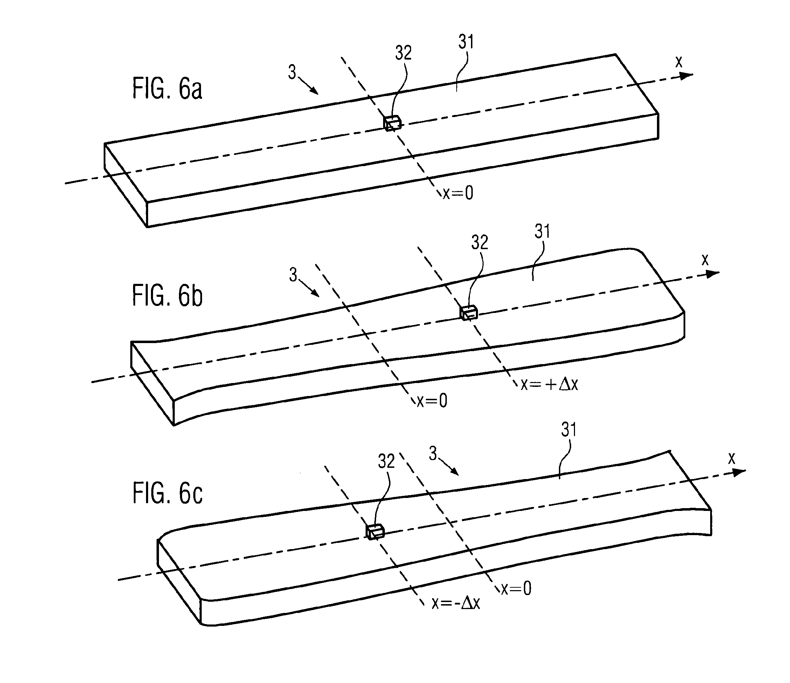

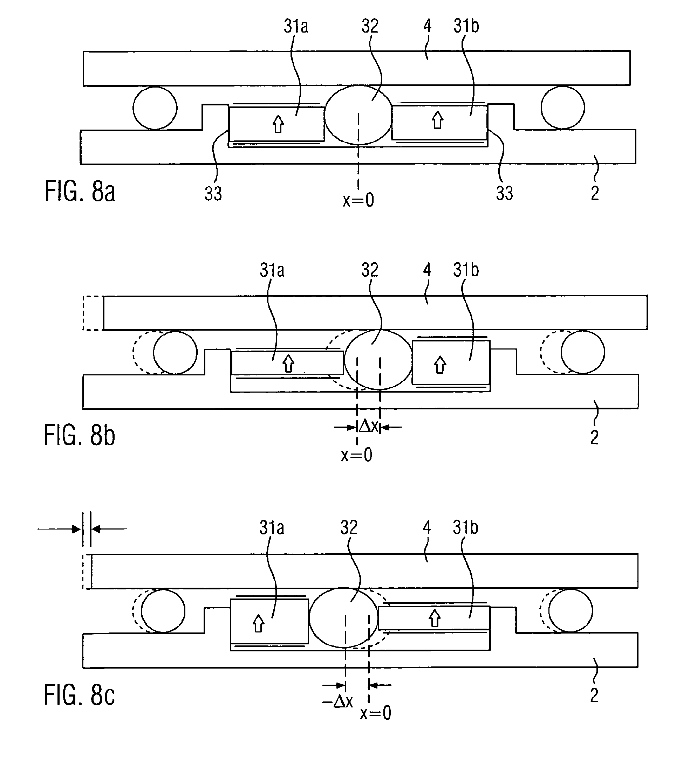

- Fig. 8: shows schematic side views of the piezoelectric motor under the load conditions similar to Figs. 6a to 6c, wherein Fig. 8a shows the motor at a rest condition of the actuator, Fig. 6b shows the motor in a condition of a deformation of the actuator upon excitation by a electric driving power in the second longitudinal mode of the piezoelectric vibrating element at the end of a first cycle, and Fig. 8c shows a condition of a deformation of the actuator upon excitation by the electric driving power in the second longitudinal mode of the piezoelectric vibrating element at the end of a second cycle.
- Fig. 9: shows graphs illustrating an electric driving power, wherein Fig. 9a shows a graph voltage vs. time, Fig. 9b shows a graph current vs. time, and wherein Fig. 9c shows a simplified current waveform.
- Fig. 10: relates is a cross-sectional view of an actuator according to a preferred aspect of the invention, wherein Fig. 10a is a cross-sectional view of an actuator, wherein the piezoelectric vibrating element has multilayer structure, and wherein Fig 10b is a schematic view of a piezoelectric motor comprising a piezoelectric element having a multilayer structure.
- Fig. 11: is a perspective view of a piezoelectric vibrating element, which is substantially embodied as a square plate, whereby the piezoelectric vibrating element is provided with a center hole and has two substantially triangular electrodes on the side surfaces, which are separated by an area extending diagonally between opposite corners of the plate.
- Fig. 12: is a perspective view of a piezoelectric actuator, whereby the piezoelectric vibrating element is substantially embodied as a square plate and a friction element is fixed in a center hole, wherein four triangular electrodes, separated by areas extending diagonally between opposite corners of the plate and crossing the center hole, respectively, are arranged on the side surfaces of the plate.
- Fig. 13: is a schematic view of a piezoelectric motor according to a second embodiment of the invention.
- Fig. 14: shows views of an autofocus module comprising the piezoelectric motor according to the second embodiment of the invention, wherein Fig. 14a shows the autofocus module without shutter, Fig. 14b shows the shutter and Fig. 14c shows an exploded view of the autofocus module.
- Fig. 15: is an exploded perspective view of elements of the piezoelectric motor according to a third embodiment of the invention, wherein the motor is embodied as rotary motor.
- Fig. 16: are exploded perspective views of the piezoelectric motor according to the third embodiment of the invention, wherein Fig. 16a is a view from the bottom and Fig. 16b is a view from the top.

### Detailed description of preferred embodiments

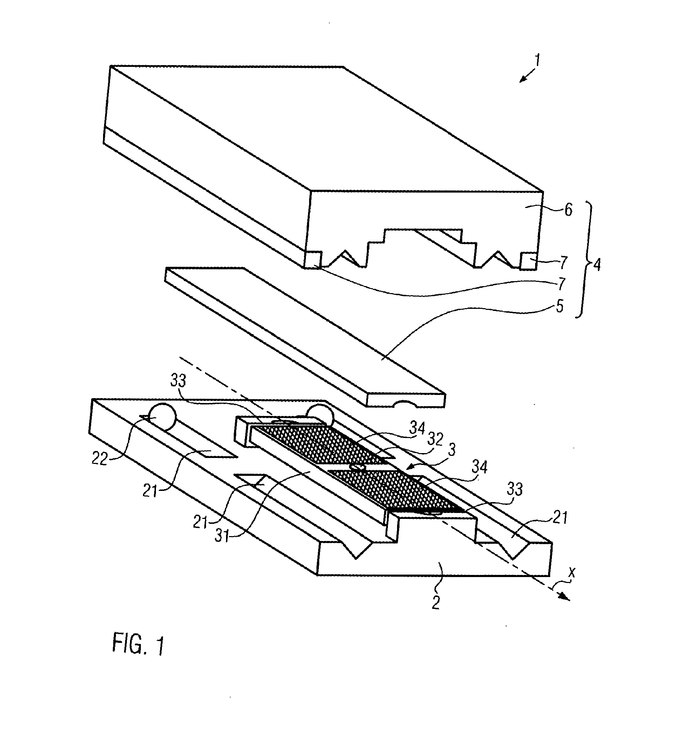

Fig. 1 is an exploded perspective view of the piezoelectric motor 1 according to the first embodiment of the invention, wherein the motor 1 is embodied as linear motor. The motor comprises a stator 2, a piezoelectric actuator 3 and a movable unit 4. The movable unit 4 comprises a friction plate 5, a slider 6 and magnets 7.

The stator 2 is embodied as substantially rectangular ferrous base plate, which is preferably made from steel. Linear guiding grooves 21 for guiding bearing balls 22 are formed in parallel with an axis x.

The piezoelectric actuator 3, which represents a separate aspect of the invention, is capable of moving the movable unit 4 relative to the stator 2 due to frictional coupling when the actuator 3 is excited by an electric driving power. The actuator 3 comprises a piezoelectric vibrating portion 31, a friction portion 32 and fixing portions 33, at which the actuator 3 is to be fixed to the stator 2, wherein the fixing portions 33 are located on opposite sides of the actuator 3. The actuator 3 is further provided with an arrangement of conductive electrodes 34, such that, upon application said of the electric driving power to the arrangement of electrodes 34, the friction portion 32 is displaced along an axis x.

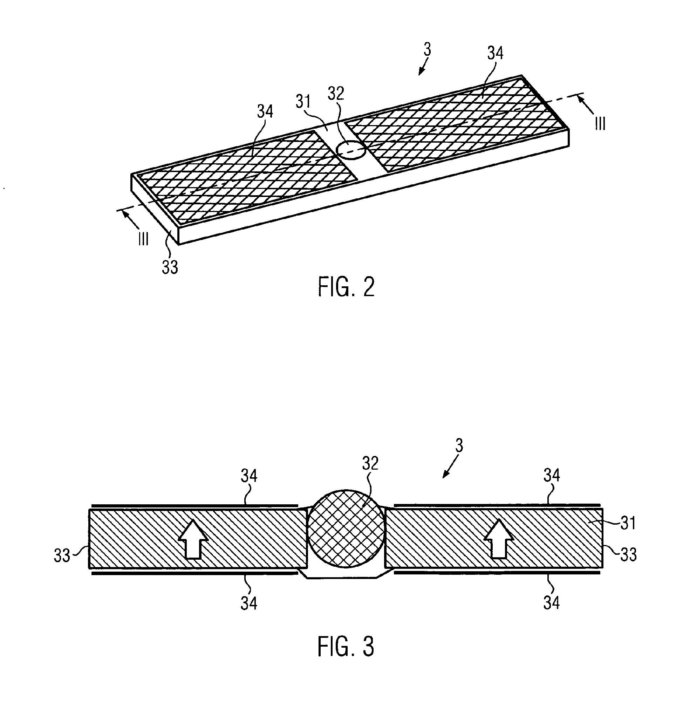

Fig. 2 is a perspective view of the actuator 3 of the motor 1 according to the first embodiment of the invention. The actuator 3 is shaped as a rectangular plate, wherein the fixing portions 33 are located on the opposite shorter edges of the plate. Conductive electrodes 34 are seen on the front surface of piezoelectric vibrating element 31. The electrodes 34 on the back surface have also the same pattern. Each electrode 34 has a rectangular shape and is arranged in a surface section of the piezoelectric vibrating portion 31 between the friction portion 32 and one of the fixing portions 33.

Fig. 3 is a sectional view of the piezoelectric actuator 3 along line III-III of Fig. 2. As can be seen from this view, the friction portion 32 is a ball shaped friction element, which is placed in the center hole of the piezoelectric vibrating element 31 and attached with epoxy resin. The friction portion 32 projects from one of the side surfaces of the plate. The electrodes 34 are symmetrically arranged on the front and back surfaces of the piezoelectric vibrating element 31. The arrows indicate the polarization directions of the piezoelectric vibrating element 31 in the sections between the friction portion 32 and the fixing portions 33. In the present case, the polarization directions are identical in the sections right and left of the friction portion 32.

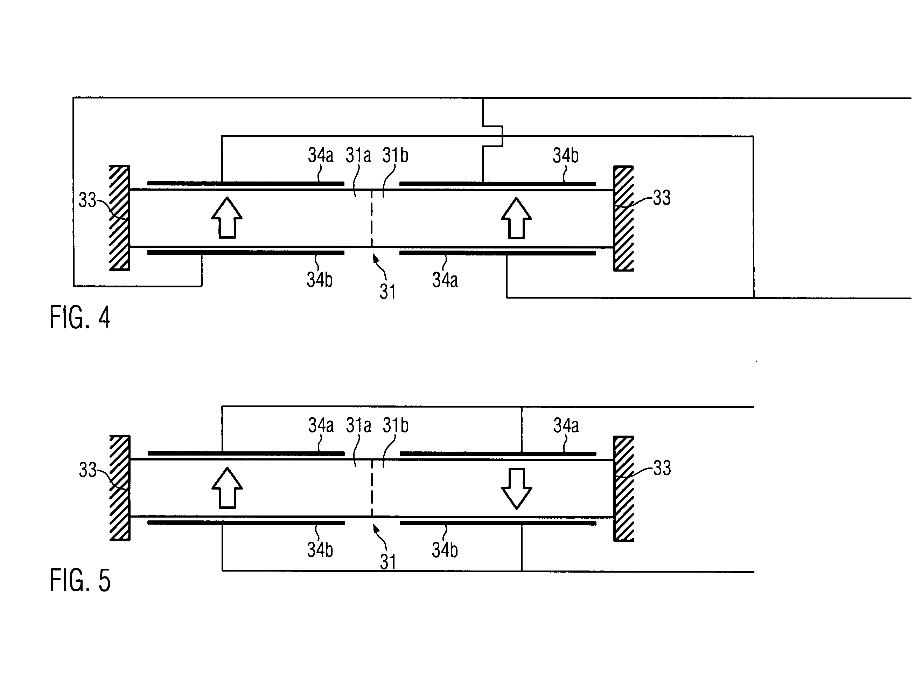

Fig. 4 is a schematic view of the piezoelectric actuator 3 as seen from the side, wherein the piezoelectric vibrating element 31 has the same polarization directions in two sections 31 a, 31 b between the friction element (not shown) and the fixing portions 33. In this configuration, a first electric line connects the upper left side electrode 34a and the bottom right side electrode 34a. Similarly, a second electric line connects upper right side electrode 34b and the lower left side electrode 34b. The ends of the piezoelectric plate 31 are fixed at the fixing portions 33 by adhesive bonding, i.e. gluing.

Fig. 5 is a schematic view of the piezoelectric actuator 3 as seen from the side, wherein the piezoelectric vibrating element 31 has opposite polarization directions in two sections 31 a, 31 b between the friction element (not shown) and the fixing portions 33. In this configuration, a first electric line connects the upper electrodes 34a and a second electric line connects the lower electrodes 34b. Again, the ends of the piezoelectric plate 31 are fixed at the fixing portions 33 by adhesive bonding, i.e. gluing.

Fig. 6 shows perspective views of a computer model of the piezoelectric actuator 3, as used in structural analyses, under different load conditions. Fig. 6a represents a rest condition of the actuator 3, wherein the friction element 32 is in the position x = 0. Fig. 6b represents a condition of a deformation of the actuator 3 upon excitation by an electric driving power in the second longitudinal mode of the piezoelectric vibrating element 31 at the end of a first cycle. As can be seen, the friction element 32 has been displaced along the axis x by an amount +Δx as compared to the rest condition of the actuator 3 shown in Fig. 6a. Fig. 6c represents a condition of a deformation of said actuator 3 upon excitation by said electric driving power in the second longitudinal mode of the piezoelectric vibrating element 31 at the end of a second cycle. As can be seen, the friction element 32 has been displaced along the axis x by an amount -Δx as compared to the rest condition of the actuator 3 shown in Fig. 6a, and by an amount -2Δx as compared to the condition of a deformation shown in Fig. 6b. Under the two different driving and poling configurations explained in context with Figs. 4 and 5, an excitation of the piezoelectric plate 31, i.e. the actuator 3, in the second longitudinal mode is very efficient. At the second longitudinal mode resonance frequency as can be seen in Figs. 6a to 6c, the center of the piezoelectric plate 31, where the friction element 32 is located, shows the largest deformation in length direction, i.e. the x-axis.

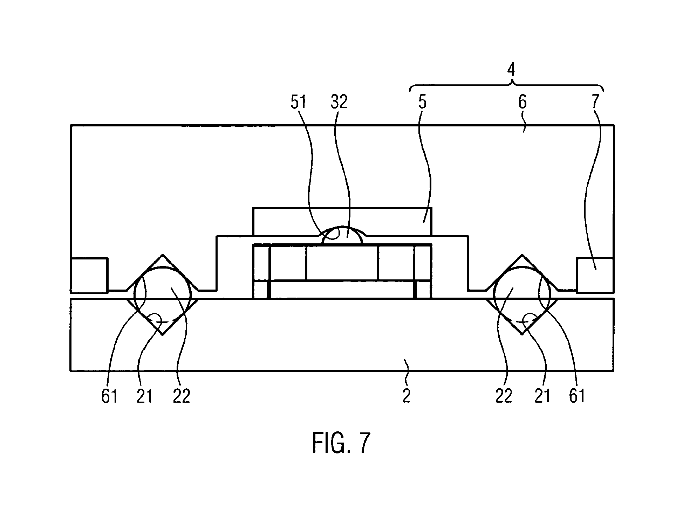

Fig. 7 is a front view of the piezoelectric motor 1 according to the first embodiment of the invention in an assembled condition. In this assembled condition, the movable unit 4 is coupled with the actuator so as to move relative to the stator 2 due to frictional coupling when the actuator is excited by the electric driving power. The actuator is fixed to the stator 2 at fixing portions, which are located on opposite ends of the actuator. The movable unit 4 is preloaded in the direction of the stator 2 by the magnets 7, which are attached to the slider 6, whereby the stator 2 attracts the magnets 7. The friction plate 5, which is also attached to the slider 6, has a longitudinal groove 51 for guiding the friction portion 32 of the actuator in order to increase the stability of linear motion of the movable unit 4. A tip of the ball-shaped friction portion 32 attached to the piezoelectric vibrating element (not seen) is in contact with the friction plate 5. Two spherical balls 22 that are moving in the grooves 21 of the stator 2 and grooves 61 of the slider 6 guide the slider 6. In order to maintain a stable movement of the movable unit 4, the slider 6 is supported in three positions.

Fig. 8 shows schematic side views of the piezoelectric motor 1 representing the load conditions of the actuator 3 similar to the Figs. 6a to 6c. In this case, the piezoelectric vibrating element 31 has the same polarization directions in two sections 31 a, 31 b between the friction element 32 and the fixing portions 33. Fig. 8a represents the rest condition of the actuator 3 according to Fig. 6a, wherein the friction portion 32 is in a position x = 0 and the stator 2 and the movable unit 4 are in neutral positions. Fig. 8b represents the condition of a deformation of the actuator 3 similar to Fig. 6b, wherein the actuator 3 is excited at the second longitudinal mode resonance frequency at positive cycle of a wave with 80 % duty ratio. As one half 31 a of the actuator expands and the other half 31 b shrinks, the friction element 32 is displaced along the x-axis by an amount +Δx as compared to the condition represented by Fig. 8a. Due to frictional coupling between the friction element 32 and the movable unit 4, the movable unit 4 moves in the same direction with the friction element 32 and is displaced along the x-axis by an amount similar to +Δx. Fig. 8c represents the condition of a deformation of the actuator 3 similar to Fig. 6c, wherein the actuator 3 is excited at the second longitudinal mode resonance frequency at negative cycle of a wave with 80 % duty ratio. In this cases, as the half 31 a of the actuator contracts and the other half 31 b expands, the friction element 32 is displaced along the x-axis by an amount -Δx as compared to the condition represented by Fig. 8a, and by an amount -2Δx as compared to the condition represented by Fig. 8b. At the negative cycle of the wave, contracted and expanded sides of the piezoelectric vibrating element are changing suddenly and the friction element 32 moves in the opposite direction. Due to inertia of the movable unit 4 and the high acceleration of the friction element 32 in the opposite direction, the movable unit 4 cannot follow the friction element 32 so slippage takes place. At the end of one period, a microscopic motion of the movable unit 4 is obtained.

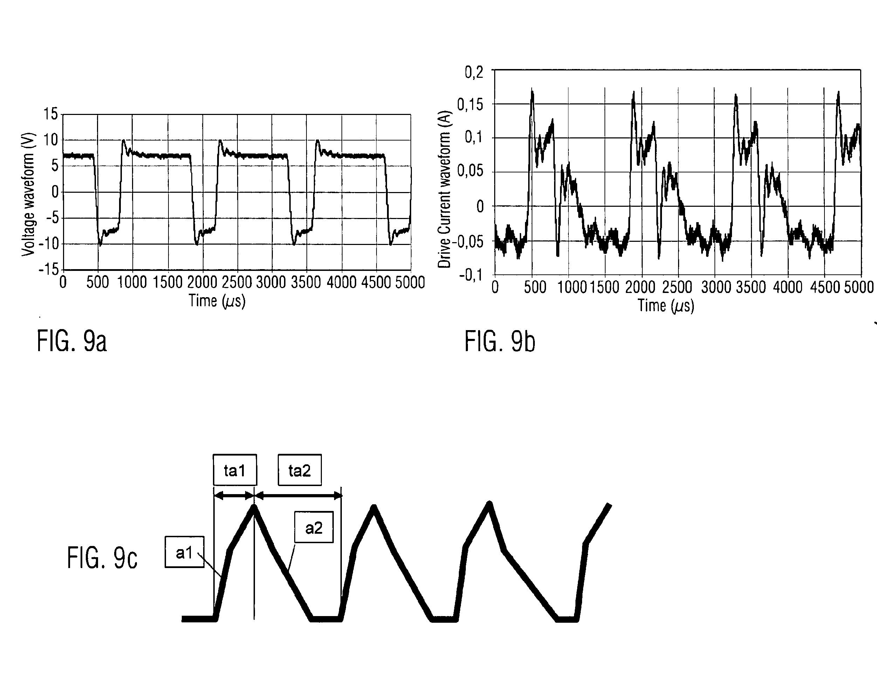

Fig. 9 shows graphs illustrating an electric driving power, wherein Fig. 9a shows a graph voltage vs. time, Fig. 9b shows a graph current vs. time and Fig. 9c shows a simplified current waveform. The electric driving power depicted in Figs. 9a and 9b can be simplified as depicted in Fig. 9c. The current waveform is directly proportional to a vibration generated on the piezoelectric element. In reaction, on the ceramic piezoelectric vibrating element, a fast acceleration a1 of the friction portion occurs in the time frame ta1 and a slow deceleration a2 of the friction portion occurs in the time frame ta2 (Fig. 9c), which cause a stick/slip motion of the movable unit, as described with reference to the Figs. 8a to 8c.

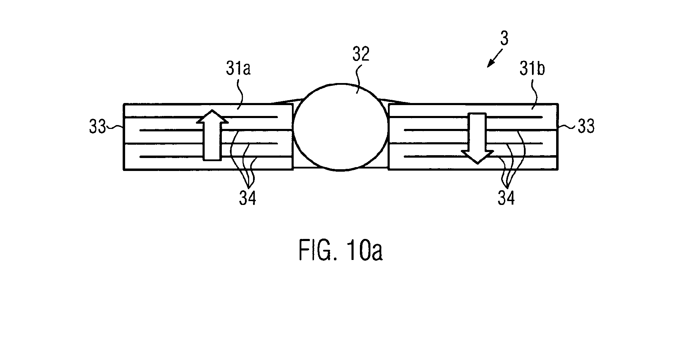

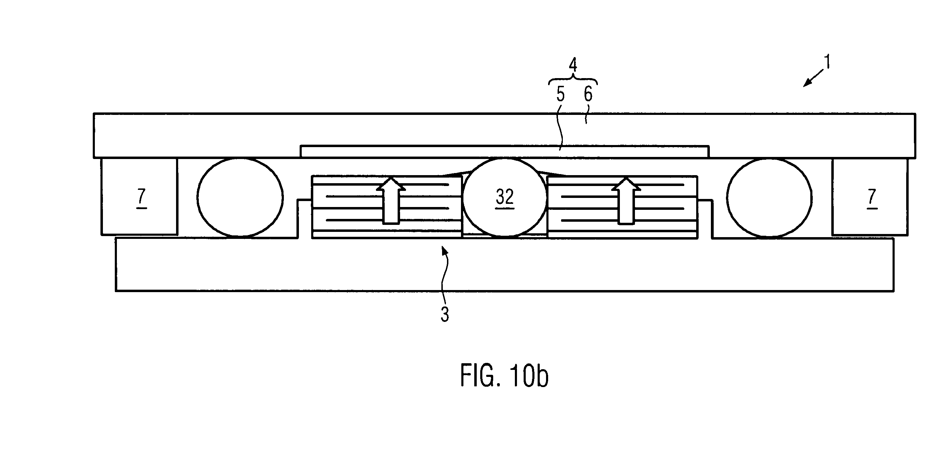

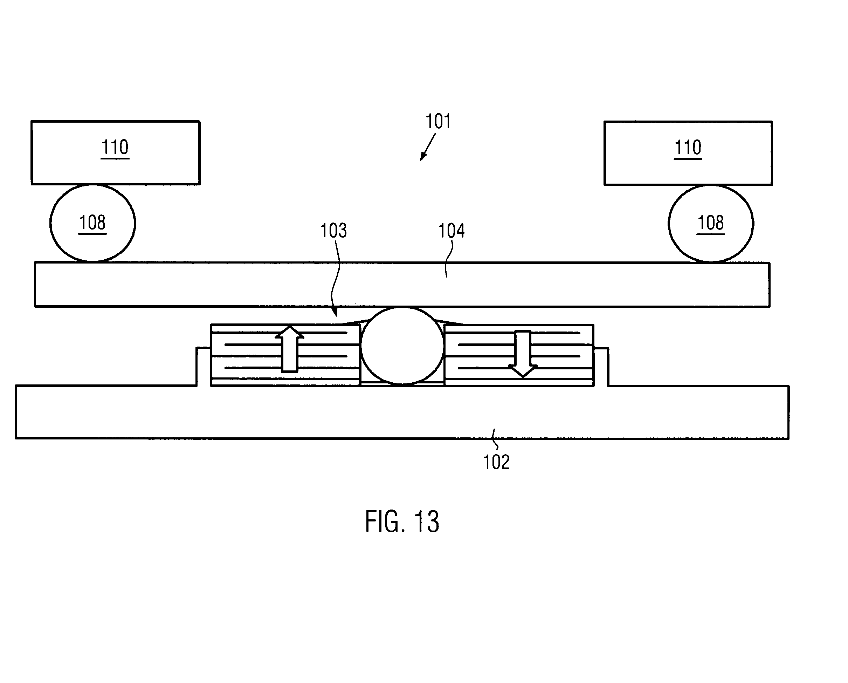

According to another preferred aspect of the invention, as can be seen in Figs, 10a, 10b and 13, the piezoelectric actuator 3 can be of a multilayer type. Fig. 10a is a cross-sectional view of the actuator 3, wherein conductive electrodes 34 are embedded in said piezoelectric actuator 3 in several parallel layers. Said embedded conductive electrodes 34 can be referred to as inner electrodes. Here, the embedded or inner electrodes 34 are stacked in height direction of the piezoelectric actuator. However, it is also possible to arrange the embedded electrodes such as to be stacked in the depth direction or in the width direction, i.e. the two possible perpendicular directions to the orientation direction of the embedded electrodes as shown in Fig. 10a, 10b and 13. It is obvious to the skilled person that the supply of electric voltage to the embedded inner electrodes is normally performed by so-called outer conductive electrodes, which are electrically connected to the embedded inner electrodes, and which are arranged at a corresponding outer surface or at corresponding outer surfaces of the piezoelectric element. As indicated by the arrows, the piezoelectric vibrating element has opposite polarization directions in two sections 31 a, 31 b between the friction element 32 and the fixing portions 33.

However, according to Fig 10b, as indicated by the arrows, the piezoelectric vibrating element has the same polarization directions in two sections between the friction element 32 and the fixing portions. The friction element 32 contacts the friction plate 5 attached to the slider 6 of the movable unit 4. The movable unit 4 is preloaded in the direction of the ferrous stator 2 by means of magnets. The actuator 3 is fixed to the stator 2 at fixing portions, which are located at opposite ends of the actuator 3.

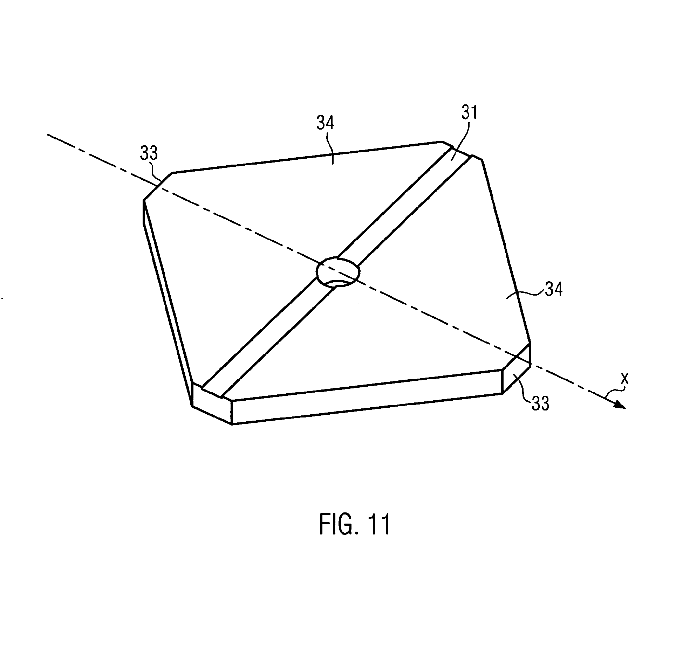

Fig. 11 is a perspective view of an actuator (without friction element 32) according to another preferred aspect of the invention, whereby the piezoelectric vibrating element 31 is substantially embodied as a square plate and has a center hole. The actuator 3 is provided with an arrangement of conductive electrodes 34, such that, upon application of an electric driving power to the arrangement of electrodes 34, the friction portion (not shown) is displaced along an axis x. In greater detail, two substantially triangular electrodes 34 are mounted on each of the surfaces of the piezoelectric vibrating element 31. An area, extending diagonally between opposite corners of the square plate and crossing the center hole, separates the triangular electrodes 34. The bottom surface of the ceramic piezoelectric vibrating element 31 has the same electrode configuration as the top surface. The axis x is perpendicular to the diagonal line separating the triangular electrodes 34. The fixing portions 33, at which the actuator/vibrating element 31 is to be fixed to a stator 2, are located on opposite corners of the square plate. The center hole is in a centered position between the fixing portions 33.

The actuator shape according to Fig. 11 results in very small fixing portions 33, which have several advantages. Due to the small fixing portions 33, the amount of a fixing means like glue can be very small, and the risk of having areas where no glue is available after having fixed the fixing portions to the stator is considerably reduced in comparison to bigger fixing portions. Thus, application of fixing means is facilitated and can be done faster, while at the same time saving adhesive material. Furthermore, the bonding is more secure. In addition, the small fixing area causes less disturbance of vibration of the piezoelectric element.

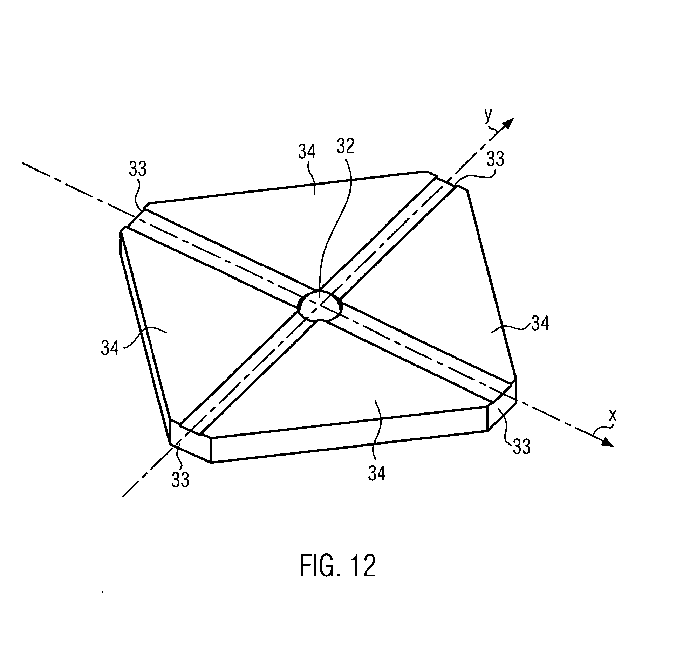

Fig. 12 is a perspective view of a piezoelectric actuator 3 according to another preferred aspect of the invention. In this so called "diamond shaped" actuator 3, the piezoelectric vibrating element 31 is substantially embodied as a square plate and the friction element 32 is fixed in the center hole by epoxy resin. The diamond shaped actuator is provided with first and second arrangements of conductive electrodes 34, such that, upon application said electric driving power to said first and second arrangements, the friction portion 32 is displaced along first and second axes x, y, respectively, wherein said first axis x is perpendicular to said second axis y. The first and said second axes x, y extend in parallel with the largest diameters of the actuator 3, which are basically imaginary lines connecting the corners of the substantially square plate and cross the center hole. In greater detail, four triangular electrodes 34 are arranged on each of the top or bottom surfaces of the piezoelectric vibrating element 31. Areas extending diagonally between opposite corners of the square plate and crossing the center hole separate the triangular electrodes 34. The bottom surface of the ceramic piezoelectric vibrating element 31 has the same electrode configuration as the top surface. Preferably, the diamond shaped actuator 3 is excited at its second longitudinal mode in one diagonal axis. The fixing portions 33, at which the actuator is to be fixed to a stator 2, are located on the four corners of the square plate. The center hole is in a centered position between the fixing portions 33.

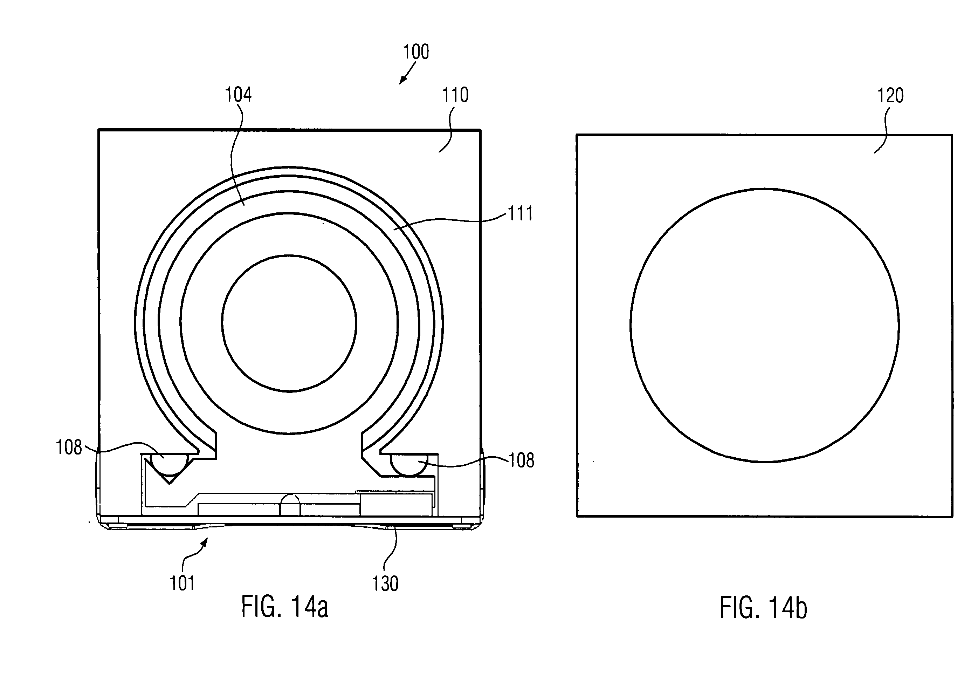

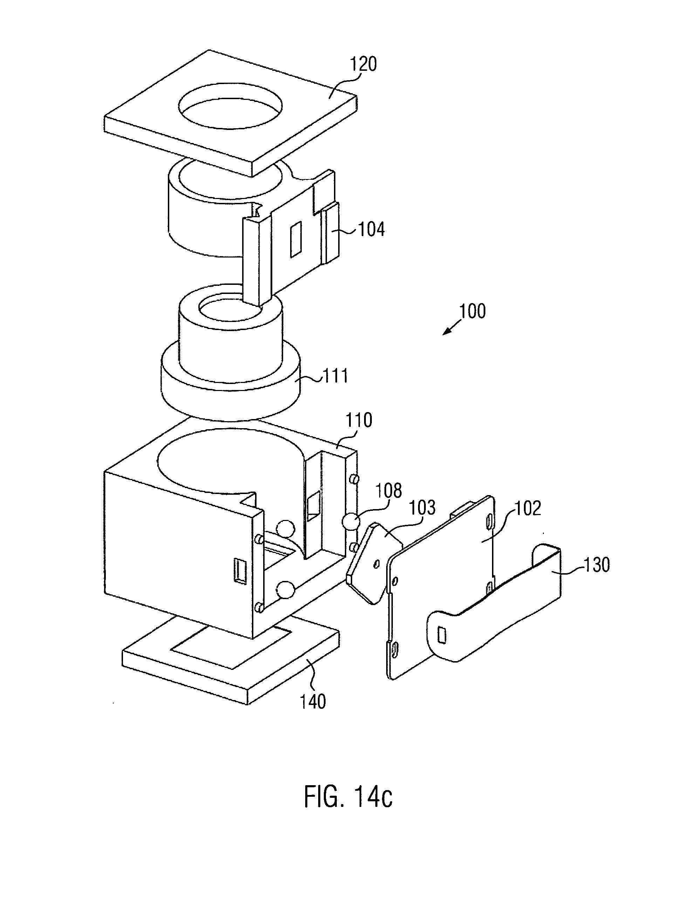

A second embodiment of the invention is now described in context with Figs. 13 and 14.

Fig. 13 is a schematic sectional view of the piezoelectric motor 101 according to a second embodiment of the invention. An actuator 103 of multilayer type according to Fig. 10a is mounted between the stator 102 and the movable unit 104. Unlike the first embodiment, a separate structure 110 supports the movable unit 104 by means of bearing balls 108.

Figs. 14a to 14c show elements of an autofocus module 100 comprising the piezoelectric motor 101 according to the second embodiment of the invention. The autofocus module 100 further comprises a housing 110, a substantially cylindrical lens barrel 111, a movable unit/slider 104, which can slide on the lens barrel 111, and a top cover/shutter 120, which is shown in Figs. 14b and 14c. The dimensions of the housing are about 10,5 mm in width and length. The lens barrel 111 has a diameter of about 8,0 mm. On the backside of the housing 110, which is shown in Fig. 14c, a printed circuit board 140 carrying a focus sensor is fixed to the housing 110. In this embodiment, the actuator 103 of the motor 101 is preferably the actuator according to Fig. 11. The actuator 103 is mounted on a flexible printed circuit board 102 together with a drive IC, position sensor or the like, wherein the flexible printed circuit board 102 forms the stator 102 in the sense of the invention. The actuator 103 is preloaded in the direction of the slider 104 by means of a spring 130, so as to enhance the frictional coupling between the actuator 103 and the slider 104. The slider 104 forms the movable unit in the sense of the invention. Even though not shown, the flexible printed circuit board 102 may comprise a hole, through and from which the spring 130 may project, so as to preload the actuator in the direction of the slider 104. The slider 104 is supported by the bearing balls 108 so as to be movable relative to the housing 110.

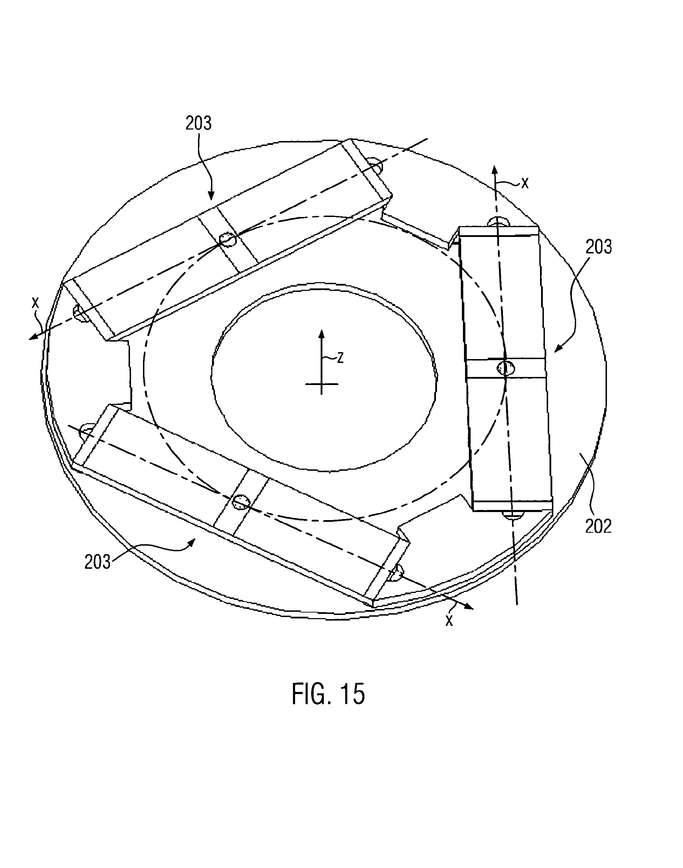

In the following figures 15 to 16, a rotary motor structure according to a third embodiment of the invention will be described.

Fig. 15 is an exploded perspective view showing elements of the piezoelectric motor according to the third embodiment of the invention. The motor according to the third embodiment is embodied as a rotary motor, wherein a movable unit is rotatable about an rotation axis z with regard to the stator 202. The actuator 203 is frictionally coupled with the movable unit in an eccentric position with regard to the rotation axis z. The axis x, along which the friction portion of the actuator can be displaced, is tangentially to a circle around said rotation axis z. Preferably, three identical piezoelectric actuators 203, as disclosed in context with Figs. 2 and 3, are used in this rotary motor. The actuators 203 are located on a circular ring type elastic base plate 202 made from steel or other ferrous material, which forms the stator 202 of this embodiment. The opposite ends of the actuators 203 are fixed on base plate 202 using epoxy or cement material. At the center of each actuator 203 a friction element is attached.

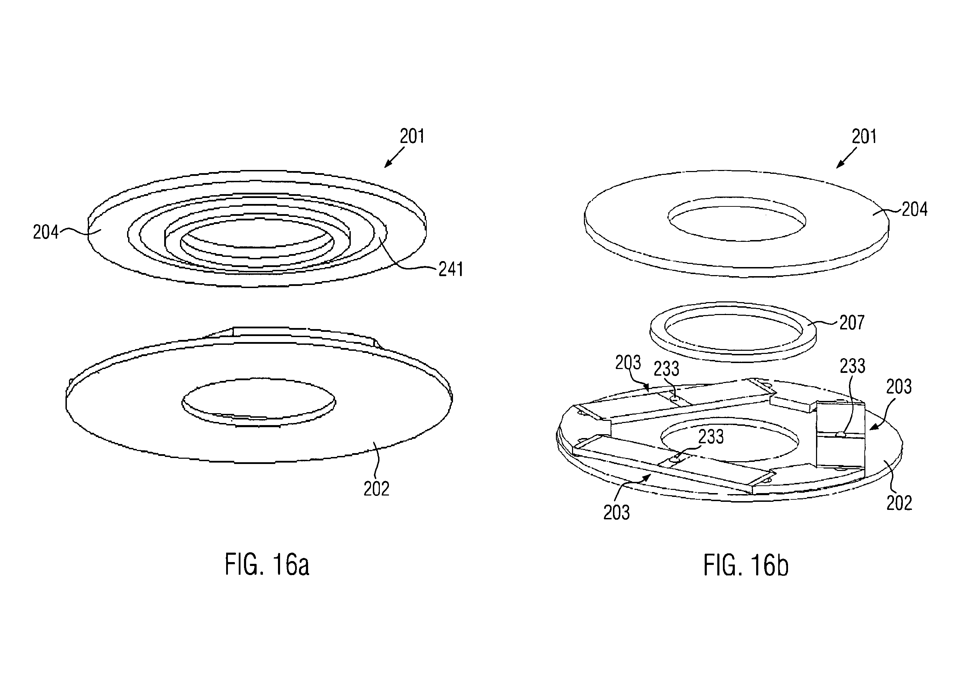

Fig. 16 shows exploded perspective views of the piezoelectric motor 201 according to the third embodiment of the invention, wherein Fig. 16a is a view from the bottom and Fig. 16b is a view from the top. An annular ring type rotor 204 forms the movable unit. A circular groove 241 is formed on the bottom of the rotor 204 facing the stator 202. The circular groove 241 is used for guiding the friction elements 233 that are located at the centers of piezoelectric actuators 203. The vibrating piezoelectric elements of the actuators 203 operate at their second longitudinal mode mechanical resonance frequency. When all three piezoelectric elements vibrate at their second mode resonance frequency, each actuator 203 applies a torque on the rotor 204. A torque due to frictional coupling between rotor 204 and the actuators 203 causes the rotor 204 to rotate. In an assembled state, the groove 241 on the rotor 204 is in contact with the friction portions 233 of the actuators 203 keeping the rotor 204 always concentric to the rotation axis z. An annular ring type magnet 207 attached to the rotor 204 applies necessary pre-stressing force in the direction of the stator 202.

A mode of operating the piezoelectric motor 1 according to the invention is described in context with the Figures 1 to 16.

The piezoelectric motor 1 according to the invention operates preferably at the second mechanical resonance frequency of its actuator 3, in particular at the second mechanical resonance frequency of its vibrating element 31. The actuator 3 is preferably shaped as a rectangular bar or square plate. In order not to suppress the useful vibration, the actuator 3 is fixed from its nodal position at fixing portions, which are located at opposite sides or ends, respectively, of the actuator 3. The maximum of vibration occurs at the center of the vibrating element 31. The movable unit 4 moves due to frictional coupling with the actuator 3 at a first cycle of the electric driving power and slips relative to said actuator 3 at a second cycle of the electric driving power. As a consequence, the movable unit 4 can be moved relative to the stator 2 into the desired position.

## Claims

1. Piezoelectric motor (1), comprising: a stator (2), a piezoelectric actuator (3) and a movable unit (4), whereby said movable unit (4) is coupled with said actuator (3) so as to move relative to said stator (2) due to frictional coupling when said actuator (3) is excited by an electric driving power, **characterized by** said actuator (3) is fixed to said stator (2) at fixing portions (33), which are located on opposite ends of said actuator (3).

2. Piezoelectric motor (1) according to claim 1, **characterized by** said actuator (3) is fixed to said stator (2) at said fixing portions (33) by fixing means, wherein a preferred fixing means is an adhesive.

3. Piezoelectric motor (1) according to any one of the preceding claims, **characterized by** piezoelectric motor (1) is a piezoelectric ultrasonic motor (1).

4. Piezoelectric motor (1) according to any one of the preceding claims, **characterized by** said actuator (3) is excited by an electric driving power having a frequency substantially equal to any even multiple of the actuator's (3) longitudinal resonance frequency.

5. Piezoelectric motor according to any one of the preceding claims, **characterized by** said actuator (3) is shaped as a bar or plate, wherein said fixing portions (33) are located on opposite edges of said bar or plate.

6. Piezoelectric motor according to any one of the preceding claims, **characterized by** said actuator (3) is shaped as a polygonal plate, preferably a square plate, wherein said fixing portions (33) are located on the corners of said plate.

7. Piezoelectric motor according to any one of the preceding claims, **characterized by** said movable unit (4) is frictionally coupled with a friction portion (32) of said actuator (3), wherein said friction portion (32) is located between said fixing portions (33), preferably in a centered position between said fixing portions (33).

8. Piezoelectric motor (1) according to any one of the preceding claims, **characterized by** said friction portion (32) projects from one of the side surfaces of said plate.

9. Piezoelectric motor (1) according to any one of the preceding claims, **characterized by** said piezoelectric actuator (3) is provided with an arrangement of conductive electrodes (34), such that, upon application said of said electric driving power to said arrangement (34), said friction portion (32) is displaced along an axis (x).

10. Piezoelectric motor (1) according to any one of the preceding claims, **characterized by** said piezoelectric actuator (3) is provided with first and second arrangements of conductive electrodes (34), such that, upon application said electric driving power to said first and second arrangements, said friction portion (32) is displaced along first and second axes (x, y), respectively, wherein said first axis (x) is substantially perpendicular to said second axis (y).

11. Piezoelectric motor (1) according to any one of the preceding claims, **characterized by** said first and/or said second axis (x, y) extends substantially in parallel with the largest diameter of said actuator (3).

12. Piezoelectric motor (1) according to any one of the preceding claims, **characterized by** said piezoelectric actuator (3) is of a multilayer type, wherein conductive electrodes (34) are embedded in said piezoelectric actuator (3) in several layers, preferably in parallel fashion.

13. Piezoelectric motor (1) according to any one of the preceding claims, **characterized by** said movable unit (4) is rotatable about an rotation axis with regard to said stator (2), wherein said actuator (3) is frictionally coupled with said movable unit (4) in an eccentric position with regard to said rotation axis.

14. Piezoelectric motor according to any one of the preceding claims, **characterized by** said axis (x) is tangentially to a circle around said rotation axis.

15. Piezoelectric motor according to any one of the preceding claims, **characterized by** said actuator (3) is preloaded in the direction of said movable unit (4) by means of a spring, so as to enhance the frictional coupling between said actuator (3) and said movable unit (4).

16. Piezoelectric motor according to any one of the preceding claims, **characterized by** said stator (2) comprises a hole, from which the spring projects in order to preload said actuator (3).

17. Autofocus module for a camera, comprising a piezoelectric motor according to any one of the preceding claims.

18. Piezoelectric actuator (3), capable of moving a movable unit (4) relative to a stator (2) due to frictional coupling when said actuator (3) is excited by a electric driving power, said actuator (3) comprising a piezoelectric vibrating portion (31), a friction portion (32) and fixing portions (33), at which the actuator (3) is to be fixed to a stator (2), **characterized by** said fixing portions (33) are located on opposite sides of said actuator (3).
